# EUROPEAN PATENT APPLICATION

(11) **EP 2 178 109 A1**
(43) Date of publication of application: **21.04.2010**
(21) Application number: 08792231.6
(22) Date of filing: 05.08.2008
(51) Int. Cl.: H01L 21/3065, C23C 14/35

(54) **PLASMA PROCESSING METHOD AND PLASMA PROCESSING APPARATUS**

(30) Priority: 08.08.2007 JP 2007206021
(71) Applicant: ULVAC, INC., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP)
(74) Representative: Albutt, Anthony John
(86) International application number: PCT/JP2008/064064
(87) International publication number: WO 2009/020129

(57) **Abstract**

[Object] To provide a plasma processing method and a plasma processing apparatus having high coverage property and excellent in-plane uniformity.

[Solving Means] When sputtered particles that are beat out from a target (31) by plasma are deposited on a surface of a substrate (W), those sputtered particles are decomposed by the plasma to thus generate active species, and then deposited on the surface of the substrate. Accordingly, a deposition mode similar to plasma CVD is obtained, and sputtering deposition with high coverage property and excellent in-plane uniformity is enabled. Particularly, since a high-frequency electric field and a ring-shaped magnetic neutral line (25) are used for a plasma source, it is possible to efficiently generate plasma that has extremely high density in a region in which a magnetic field is zero. That plasma realizes plasma processing with high in-plane uniformity by arbitrarily adjusting a formation position and a size of the magnetic neutral line.

## Description

### Technical Field

The present invention relates to a plasma processing method and a plasma processing apparatus that use NLD (magnetic Neutral Loop Discharge).

### Background Art

In a thin-film manufacturing process in the semiconductor manufacturing field, a deposition process of forming a thin film for wiring or an insulating thin film on a surface of a substrate is performed. For a deposition apparatus, a plasma CVD apparatus or a sputtering apparatus is widely used.

As the sputtering apparatus, there is known a magnetron sputtering apparatus in which an electromagnet or permanent magnet is arranged on a rear surface of a target, ring-shaped magnetron discharge plasma is then generated on a front surface of the target to thereby sputter the target, sputtered materials are deposited on a substrate, and a film is thus formed (see Patent Document 1). Since the magnetron sputtering apparatus can form plasma efficiently, it can perform deposition under a relatively low temperature and a low gas pressure and also has an advantage in high deposition rate.

Further, conventionally, a plasma etching (dry etching) method has been widely used for processing of a surface of a silicon substrate. A reaction of atomic (radical) fluorine to silicon at room temperature is spontaneously caused and a relatively high etching rate is obtained. Therefore, in etching of the silicon substrate, gas containing fluorine, such as SF₆, NF₃, COF₂, and XeF₂, is frequently used as etching gas. However, since dry etching of the silicon substrate in which etching gas containing fluorine is used is isotropic, the etching is also advanced on side surfaces of a depressed portion of a formed projection-depression pattern (etching pattern). Accordingly, it has been difficult to form a fine via having a high aspect ratio, such as a through hole and a deep trench, with high accuracy.

In this regard, there has been recently proposed a deep processing technique of a silicon substrate, in which by performing etching while forming a protective film on the side surfaces of the pattern, expansion of etching in a lateral direction can be suppressed and perpendicularity of the side surfaces of the pattern can be kept.

For example, Patent Documents 2 and 3 disclose a method in which, by alternately repeating an etching process and a protective film forming process, etching is performed while forming a protective film made of a polymer layer on a bottom surface and side surfaces of a pattern that is exposed in the etching process. Since the polymer layer formed on the side surfaces of a depressed portion in the protective film forming process is less removed in the etching process than the polymer layer formed on the bottom surface of the pattern, the polymer layer formed on the side surfaces of the pattern functions as an etching protective film and thus anisotropic etching in which an etching direction is limited to a depth direction of the pattern can be realized.

Particularly in Patent Document 2, a CVD method using a CHF-based gas is disclosed as a deposition method for the protective film. Further, in Patent Document 3, a sputtering method using an argon gas with respect to a spattering target arranged opposed to a substrate is disclosed as a deposition method for the protective film.

Patent Document 1: Japanese Patent Application Laid-open No. 2001-271163
Patent Document 2: US Patent No. 5,501,893
Patent Document 3: WO2006/003962

### Disclosure of the Invention

### Problem to be solved by the Invention

Generally, in a sputtering apparatus, since sputtered particles (sputtered materials) that are beat out from a target surface due to collision with ions in plasma linearly enter a substrate, deposition accuracy with respect to a stepped portion of a substrate surface or a side wall of a hole or groove having a high aspect ratio is largely affected by a geometric arrangement relationship between the substrate and the target. Therefore, there arises a problem that uniform coverage property cannot be ensured over the entire deposition area of the substrate surface. Particularly in the magnetron sputtering apparatus, variations of an erosion rate of the target that result from a distribution of plasma density make it more difficult to ensure the uniformity.

On the other hand, in the field of the deep processing technique of a silicon substrate, it is required to increase processing accuracy and improve productivity. In order to increase processing accuracy of the deep processing technique, it is indispensable to highly accurately control a shape of an etching pattern. Accordingly, accuracy of a shape of a formed via is intended to be increased while preventing side etching of the via with a protective film.

In this case, coverage property of the protective film that covers a depressed potion of the etching pattern becomes an important element. The coverage property becomes difficult to be controlled in general, as the shape of the pattern is finer and depth of the pattern is deeper. In addition, in order to improve productivity, an in-plane distribution of the coverage property has to be increased. Accordingly, in order to obtain a substrate including a via with a desired pattern shape with high productivity, a technique capable of increasing the coverage property of the protective film and highly controlling the in-plane distribution thereof.

In view of the circumstances as described above, an object of the present invention is to provide a plasma processing method and a plasma processing apparatus having high coverage property and excellent in-plane uniformity.

### Means for solving the Problem

According to an embodiment of the present invention, there is provided a plasma processing method of generating plasma inside a vacuum chamber and alternately repeating a process of etching a substrate and a process of forming a protective film on a side wall portion of an etching pattern.
The process of forming the protective film includes forming a high-frequency electric field and a magnetic neutral line between the substrate and a target material arranged opposite to the substrate and generating plasma. The target material is sputtered and sputtered materials thereof are decomposed by the plasma and deposited on the substrate.

According to an embodiment of the present invention, there is provided a plasma processing apparatus including a vacuum chamber, a stage, a target material, and a plasma source.
The stage is used for supporting a substrate, and installed inside the vacuum chamber. The target material is installed opposite to the stage. The plasma source includes an electric field formation means for forming a high-frequency electric field within the vacuum chamber and a magnetic field formation means for forming a magnetic neutral line within the vacuum chamber. The plasma source etches the substrate or sputters the target material by plasma generated between the stage and the target material by the electric field formation means and the magnetic field formation means, and decomposes sputtered materials thereof by the plasma to thereby deposit the sputtered materials on the substrate.

### Best Modes for Carrying Out the Invention

According to an embodiment of the present invention, there is provided a plasma processing method of generating plasma inside a vacuum chamber and alternately repeating a process of etching a substrate and a process of forming a protective film on a side wall portion of an etching pattern.
The process of forming the protective film includes forming a high-frequency electric field and a magnetic neutral line between the substrate and a target material arranged opposite to the substrate and generating plasma. The target material is sputtered and sputtered materials thereof are decomposed by the plasma and deposited on the substrate.

In the plasma processing method, when the sputtered materials that are beat out from the target by the plasma are deposited on a surface of the substrate, those sputtered materials are decomposed and re-excited by the plasma, and ions or active species are generated. Accordingly, a deposition mode similar to plasma CVD is obtained and sputtering deposition with high coverage property and excellent in-plane uniformity is enabled.

In particular, since the high-frequency electric field and the magnetic neutral line are used for the plasma source, it is possible to efficiently generate plasma that has extremely high density in a region in which a magnetic field is zero. The plasma is one mode of high-density plasma that is referred to NLD (magnetic Neutral Loop Discharge), and makes it possible to realize plasma processing of high in-plane uniformity by arbitrarily adjusting a formation position and a size of the magnetic neutral line.

In the plasma processing method described above, the sputtered materials of the target are decomposed by the plasma and deposited on the substrate. Accordingly, sputtering deposition with high coverage property and excellent in-plane uniformity is enabled.

In the plasma processing method described above, the target material can be selected as appropriate in accordance with a type of materials to be deposited, such as a synthetic resin, silicon, carbon, silicon carbide, silicon oxide, or silicon nitride. Further, for process gas, inert gas including noble gas such as argon, fluorine-containing gas such as C₄F₈ and CHF₃, or mixed gas of those gases can be used. The fluorine-containing gas itself can function as deposition gas and, for example, enables reactants of decomposition products of the gas and sputtered materials to be deposited on the substrate.

According to an embodiment of the present invention, there is provided a plasma processing apparatus including a vacuum chamber, a stage, a target material, and a plasma source.
The stage is used for supporting a substrate, and installed inside the vacuum chamber. The target material is installed opposite to the stage. The plasma source includes an electric field formation means for forming a high-frequency electric field within the vacuum chamber and a magnetic field formation means for forming a magnetic neutral line within the vacuum chamber. The plasma source etches the substrate or sputters the target material by plasma generated between the stage and the target material by the electric field formation means and the magnetic field formation means, and decomposes sputtered materials thereof by the plasma to thereby deposit the sputtered materials on the substrate.

In the plasma processing apparatus described above, when the sputtered materials that are beat out from the target by the plasma are deposited on a surface of the substrate, those sputtered materials are decomposed and re-excited by the plasma, and ions or active species are generated. Accordingly, a deposition mode similar to plasma CVD is obtained and sputtering deposition with high coverage property and excellent in-plane uniformity is enabled.

Hereinafter, descriptions will be given on embodiments of the present invention with reference to the drawings.

### (First embodiment)

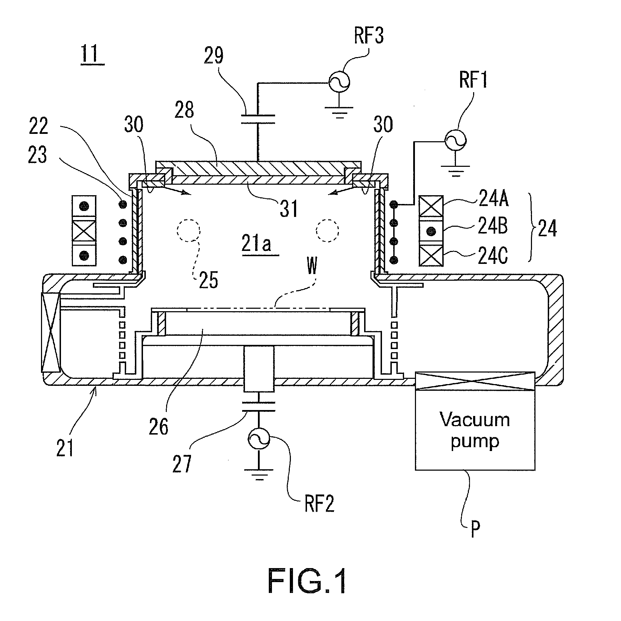

Fig. 1 is a schematic structural diagram of a plasma processing apparatus 11 for implementing a plasma processing method according to a first embodiment of the present invention. The plasma processing apparatus 11 shown in the figure has functions as an NLD (magnetic Neutral Loop Discharge) plasma etching apparatus and as a sputtering apparatus using NLD.

In Fig. 1, a vacuum vessel 21 forms a vacuum chamber including a plasma forming space 21a. A vacuum pump P such as a turbo-molecular pump is connected to the vacuum vessel 21, and an inside of the vacuum vessel 21 is evacuated to a predetermined degree of vacuum.

A circumference of the plasma forming space 21a is partitioned with a cylindrical wall 22 constituting a part of the vacuum vessel 21. The cylindrical wall 22 is constituted of a transparent insulating material such as quartz. On an outer circumferential side of the cylindrical wall 22, there are arranged a high-frequency coil (antenna) 23 for generating plasma (electric field formation means), which is connected to a first high-frequency power source RF1, and a magnetic coil group 24 constituted of three magnetic coils 24A, 24B, and 24C (magnetic field formation means) that are arranged on an outer circumferential side of the high-frequency coil 23.

The magnetic coil 24A and the magnetic coil 24C are supplied with current in the same direction and the magnetic coil 24B is supplied with current in the opposite direction of the other magnetic coils 24A and 24C. As a result, a magnetic neutral line 25 in which a magnetic field is zero is continuously formed in a ring shape in the plasma forming space 21a. Then, by an induction electric field (high-frequency electric field) being formed by the high-frequency coil 23 along the magnetic neutral line 25, discharge plasma is generated.

Particularly in an NLD plasma processing apparatus, a formation position and a size of the magnetic neutral line 25 can be adjusted depending on an amount of current that is caused to flow into the magnetic coils 24A to 24C. That is, when current caused to flow into the magnetic coils 24A, 24B, and 24C are represented by I_{A}, I_{B}, and I_{C}, respectively, the formation position of the magnetic neutral line 25 is lowered toward the magnetic coil 24C side in a case where I_{A} > I_{C} is satisfied, and conversely, the formation position of the magnetic neutral line 25 is raised toward the magnetic coil 24A side in a case where I_{A} < I_{C} is satisfied. Moreover, when an amount of the current I_{B} caused to flow into the intermediate magnetic coil 24B is increased, a ring diameter of the magnetic neutral line 25 becomes small and simultaneously a magnetic filed gradient becomes gentle at a zero position of the magnetic filed. By utilizing those characteristics, it is possible to achieve optimization of a plasma density distribution.

On the other hand, a stage 26 that supports a substrate W to be processed, such as a semiconductor wafer (for example, silicon substrate) and a glass substrate, is installed inside the vacuum chamber. In this embodiment, a silicon substrate is used as the substrate W to be processed. The stage 26 is constituted of a conductor and is connected to a second high-frequency power source RF2 via a capacitor 27. It should be noted that the stage 26 may incorporate a heating source such as a heater for heating the substrate W to a predetermined temperature.

A top panel 28 is installed at an upper portion of the plasma forming space 21a. The top panel 28 is structured as a counter electrode of the stage 26 and connected with a third high-frequency power source RF3 via a capacitor 29. On a surface of the top panel 28 on the plasma forming space 21a side, a target material 31 for forming a film on the substrate W by sputtering is attached. Though a fluorine resin material such as polytetrafluoroethylene (PTFE) is used as the target material 31 in this embodiment, any other synthetic resin materials, silicon materials, carbon materials, silicon carbide materials, silicon oxide materials, silicon nitride materials, and the like are applicable.

In the vicinity of the top panel 28, a gas introduction member 30 for introducing process gas into the vacuum vessel 21 is installed. Other than noble gas or inert gas such as argon and nitrogen, fluorine-containing gas such as C₄F₈ and CHF₃ or mixed gas of those inert gas and fluorine-containing gas is used as process gas for sputtering. In particular, the fluorocarbon-based gas itself, such as C₄F₈ and CHF₃ serving as process gas, can function as deposition gas and, for example, enables reactants of decomposition products of the gas and sputtered materials of the target material 31 to be deposited on the substrate W. As etching gas, at least one kind of SF₆, NF₃, SiF₄, XeF₂, and COF₂ or mixed gas with inert gas is used. In this embodiment, mixed gas of SF₆ and Ar is used as etching gas.

In the plasma processing apparatus 11 of this embodiment that is structured as described above, by alternately repeating an etching process and a protective film forming process with respect to the substrate W placed on the stage 26, a via constituted of a hole, a deep trench, or the like having a high aspect ratio is formed on a surface of the substrate.

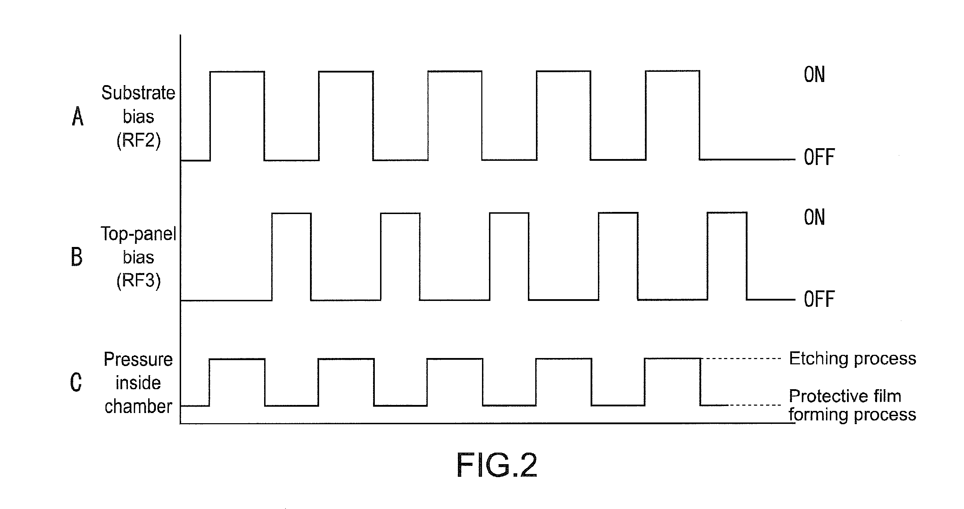

Fig. 2 is a timing chart showing an operation example of the plasma processing apparatus 11 of this embodiment. In Fig. 2, A is an application timing of the second high-frequency power source RF2 that is applied to the stage 26, B is an application timing of the third high-frequency power source RF3 that is applied to the top panel 28, and C is a pressure change inside the vacuum vessel 21. In this example, a processing pressure of the etching process (introduction amount of process gas) is set to be higher than that of the protective film forming process. It should be noted that the first high-frequency power source RF1 is constantly input to the high-frequency coil 23 through the etching process and the protective film forming process.

On the surface of the substrate W, a resist mask is formed in advance. For the resist mask, an organic resist, a metal mask, or the like is used. In the etching process and the protective film forming process, the ring-shaped magnetic neutral line 25 is formed by the magnetic coil group 24 and inductively-coupled plasma is also formed along the magnetic neutral line 25 due to power input to the high-frequency coil 23 from the first high-frequency power source RF1 in the plasma forming space 21a.

In the etching process, the etching gas (for example, Ar and SF₆) introduced into the vacuum vessel 21 is changed into plasma in the plasma forming space 21a, and the substrate W on the stage 26 is subjected to etching processing by generated ions and radicals. At this time, a substrate bias is turned ON due to power input from the second high-frequency power source RF2, the ions are accelerated to the stage 26 side, and radical products on the substrate are removed by sputtering, to thereby increase etching property. In other words, fluorine radicals react with silicon to form radical products, and by removing them by sputtering effect due to ions in the plasma, the etching processing of the silicon substrate advances.

On the other hand, after performing the etching process for a predetermined time period, the etching gas remaining inside the vacuum vessel 21 is exhausted. Then, the process gas for deposition (for example, Ar) is introduced into the vacuum vessel 21 and the protective film forming process is thus started. The introduced process gas is changed into plasma in the plasma forming space 21a. At this time, the substrate bias (RF2) is turned OFF and a top-panel bias is turned ON due to the power input from the third high-frequency power source RF3 instead. As a result, the target material 31 arranged on the top panel 28 is sputtered by the ions in the plasma, and the sputtered materials adhere to the surface of the substrate W and a depressed portion formed in the etching process described above. As described above, a polymer layer functioning as a protective film is formed on a bottom surface and side surfaces of the etched depressed portion.

Here, sputtered particles that are beat out from the target material 31 pass through NLD plasma formed in the plasma forming space 21a and reach the substrate W. At this time, by being decomposed and re-excited in a high-density plasma region in which the magnetic neutral line 25 is formed, the sputtered particles isotropically enter the surface of the substrate W in a deposition mode similar to a chemical vapor deposition method (CVD method). Accordingly, a step coating film (protective film) of an etching pattern obtained by this embodiment has high coverage property and excellent in-plane uniformity, as compared to a sputtering process by only ICP plasma in which the magnetic neutral line 25 is not formed.

After the protective film forming process is performed for a predetermined time period, the etching process described above is performed again. An initial stage of this etching process is spent on an operation of removing the protective film that covers the bottom surface of the etched depressed portion. After that, the etching processing for the bottom surface of the etched depressed portion that is exposed by removing the protective film is restarted. At this time, the ions of the etching gas in the plasma enter the substrate in a vertical direction due to the substrate bias effect. So, the ions that reach the protective film that covers the side surfaces of the etched depressed portion are less than the ions that reach the bottom surface of the etched depressed portion. Accordingly, during the etching process, the protective film covering the side surfaces of the etched depressed portion is left without being removed completely. Thus, contact between the side surfaces of the etched depressed portion and the fluorine radicals is avoided, and the side surfaces of the depressed portion are prevented from being eroded by etching.

Hereinafter, by alternately repeating the etching process and the protective film forming process described above, anisotropic etching in the vertical direction with respect to the surface of the substrate is realized. As described above, a via (contact hole, trench) having a high aspect ratio is manufactured inside the substrate W.

According to this embodiment, when the protective film as a step coating film that covers the etching pattern including the mask pattern on the substrate W is formed, high coverage property can be obtained by performing sputtering processing using the ICP plasma in the presence of the magnetic neutral line 25, as compared to a case of performing sputtering processing using only the ICP plasma without forming a magnetic neutral line.

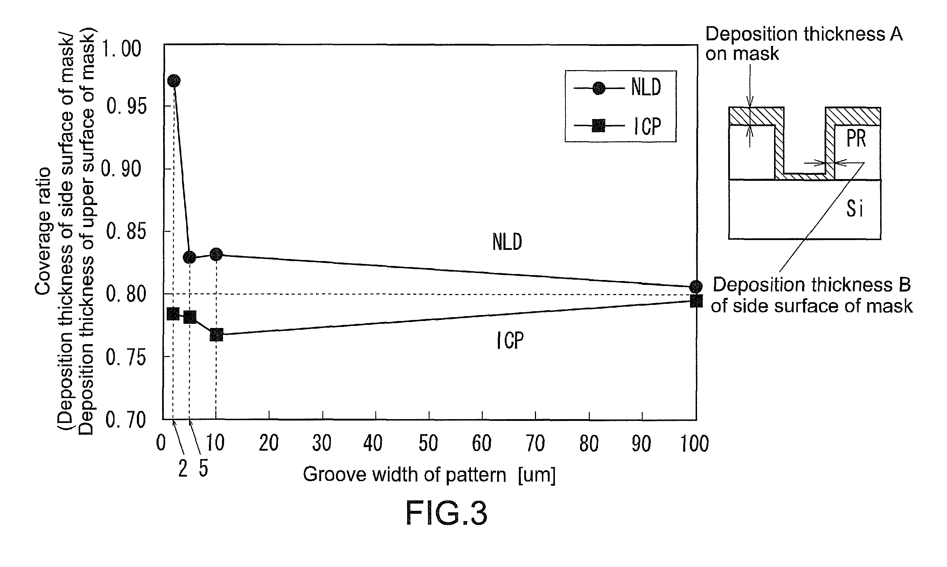

Fig. 3 indicates experiment results showing a relationship between a groove width of a mask pattern and a coverage ratio in the sputtering processing using the NLD according to the present invention. It should be noted that as comparison, coverage characteristics of a case where sputtering processing is performed using only the ICP plasma without forming a magnetic neutral line (hereinafter, also referred to simply as "ICP sputtering") are also shown in Fig. 3.

As shown in Fig. 3, the coverage ratio is defined as a ratio (B/A) of a film thickness (deposition thickness) B of a side surface of the mask (side surface of depressed portion of projection-depression pattern) to a film thickness (deposition thickness) A of an upper surface of the mask (upper surface of projecting portion of projection-depression pattern), for a step coating film that covers the mask pattern PR formed in a thickness 1 µm on the surface of the silicon substrate (diameter of 20 cm (8 inches)). PTFE was used as the target material. NLD and ICP sputtering conditions are as follows.

### (NLD sputtering conditions)

· Process gas: Ar 30 [sccm]
· High-frequency power RF1: 3,000 [W] 13.56 [MHz]
   RF2: 0 [W]
   RF3: 500 [W] 12.50 [MHz]
· Processing time: 4 [sec]
· Processing pressure: 2.6 [Pa]
· Current of magnetic coil Magnetic coil 24A: 30.6 [A]
   Magnetic coil 24B: 49.3 [A]
   Magnetic coil 24C: 30.6 [A]
Diameter of ring-shaped magnetic neutral line: 146 [mm]

### (ICP sputtering conditions)

· Process gas: Ar 30 [sccm]
· High-frequency power RF1: 3,000 [W] 13.56 [MHz]
   RF2: 0 [W]
   RF3: 500 [W] 12.50 [MHz]
· Processing time: 4 [sec]
· Processing pressure: 2.6 [Pa]

As apparent from the results of Fig. 3, when a width (groove width) of the depressed portion of the mask pattern was equal or smaller than 100 µm, the coverage ratio in the case of the ICP sputtering was below 0.8 (80%), whereas the coverage ratio exceeding 0.8 was obtained in the case of the NLD sputtering. The reason is thought that the NLD sputtering has a higher re-excitation efficiency of the sputtered particles due to plasma than the ICP sputtering, and thus a generation amount of radicals that are electrically neutral is larger in the NLD sputtering and sputtered materials that isotropically enter the mask pattern on the substrate are increased.

The difference between re-excitation efficiencies of the sputtered particles due to the plasma appears in a difference between material compositions of a sputtered film formed on the substrate. Figs. 4, 5, and 6 each show a C1ₛ waveform separation spectrum measured for a target material, an ICP sputtered film, or an NLD sputtered film. When comparing waveform separation results of the sputtered film by the ICP (Fig. 5) and waveform separation results of the sputtered film by the NLD (Fig. 6) with each other, correlations among magnitudes of peaks of "CF2", "CF" and "C-C" are different, and a difference between compositions of both the sputtered films is found.

Further, as shown in Fig. 3, in the case of the NLD sputtering, it is found that when the groove width of the depressed portion of the pattern is equal to or smaller than 5 µm, the coverage ratio is drastically increased. Moreover, when the groove width was 2 µm, a coverage ratio of 0.97, which was extremely high, was obtained. In such a manner, as the projection-depression pattern has finer pitches, effect by the NLD sputtering becomes significant and coverage characteristics excellent with respect to the finer pattern can be obtained.

Next, descriptions will be given on evaluation results on in-plane uniformity of a pattern shape when the silicon substrate is subjected to deep processing by alternately repeating the etching process and the sputtering process (protective film forming process).

A resist pattern was formed on the surface of the silicon substrate (diameter of 20 cm (8 inches)), and the deep processing was performed, with the resist pattern being used as a mask, by alternately repeating the etching process and the protective film forming process (sputtering process). The processes were performed in combination of ICP etching in which a magnetic neutral line was not formed (hereinafter, also referred to simply as "ICP etching") and the ICP sputtering, and in combination of the NLD etching and the NLD sputtering.

ICP etching conditions and ICP sputtering conditions are as follows.

### (ICP etching conditions)

· Process gas: Ar 30 [sccm]
   SF₆ 300 [sccm]
· High-frequency power RF1: 1,500 [W] 13.56 [MHz]
   RF2: 60 [W] 12.50 [MHz]
   RF3: 0 [W]
· Processing time: 7 [sec]
· Processing pressure: 10 [Pa]

### (ICP sputtering conditions)

· Process gas: Ar 30 [sccm]
· High-frequency power RF1: 3,000 [W] 13.56 [MHz]
   RF2: 0 [W]
   RF3: 500 [W] 12.50 [MHz]
· Processing time: 4 [sec]
· Processing pressure: 2.6 [Pa]

NLD etching conditions and NLD sputtering conditions are as follows.

### (NLD etching conditions)

· Process gas: Ar 30 [sccm]
   SF₆ 300 [sccm]
· High-frequency power RF1: 1,500 [W] 13.56 [MHz]
   RF2: 60 [W] 12.50 [MHz]
   RF3: 0 [MHz]
· Processing time: 7 [sec]
· Processing pressure: 10 [Pa]
· Current of magnetic coil Magnetic coil 24A: 30.6 [A]
   Magnetic coil 24B: 54.0 [A]
   Magnetic coil 24C: 30.6 [A]

### (NLD sputtering conditions)

· Process gas: Argon (Ar) 30 [sccm]
· High-frequency power RF1: 3,000 [W] 13.56 [MHz]
   RF2: 0 [W]
   RF3: 500 [W] 12.50 [MHz]
· Processing time: 4 [sec]
· Processing pressure: 2.6 [Pa]
· Current of magnetic coil Magnetic coil 24A: 30.6 [A]
   Magnetic coil 24B: 49.3 [A]
   Magnetic coil 24C: 30.6 [A]
Diameter of ring-shaped magnetic neutral line: 146 [mm]

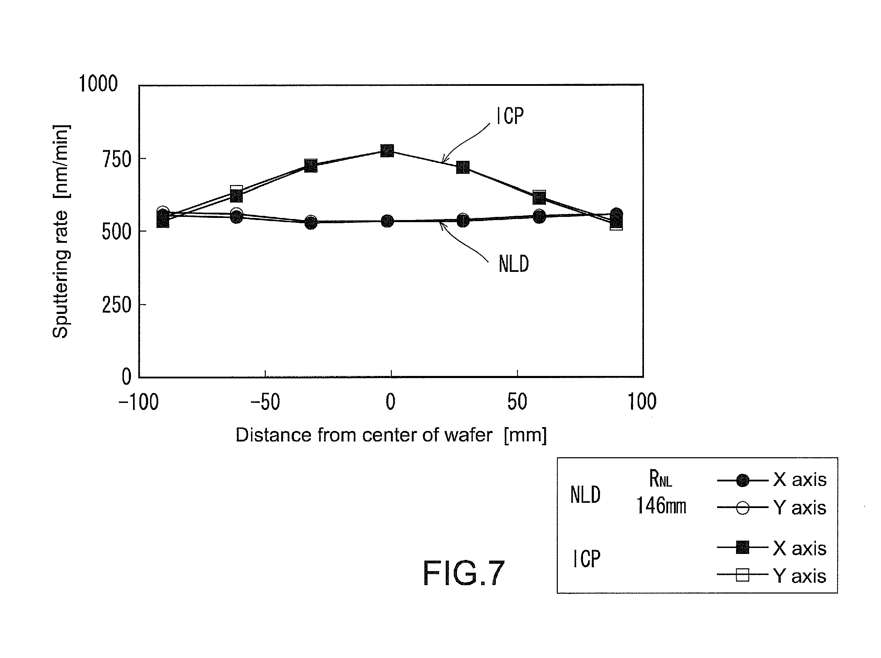

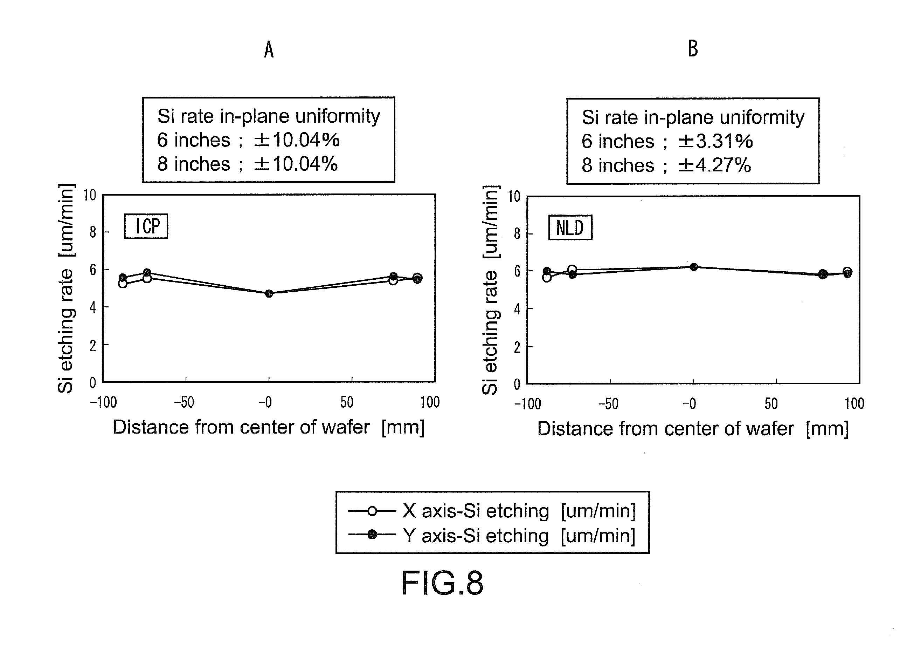

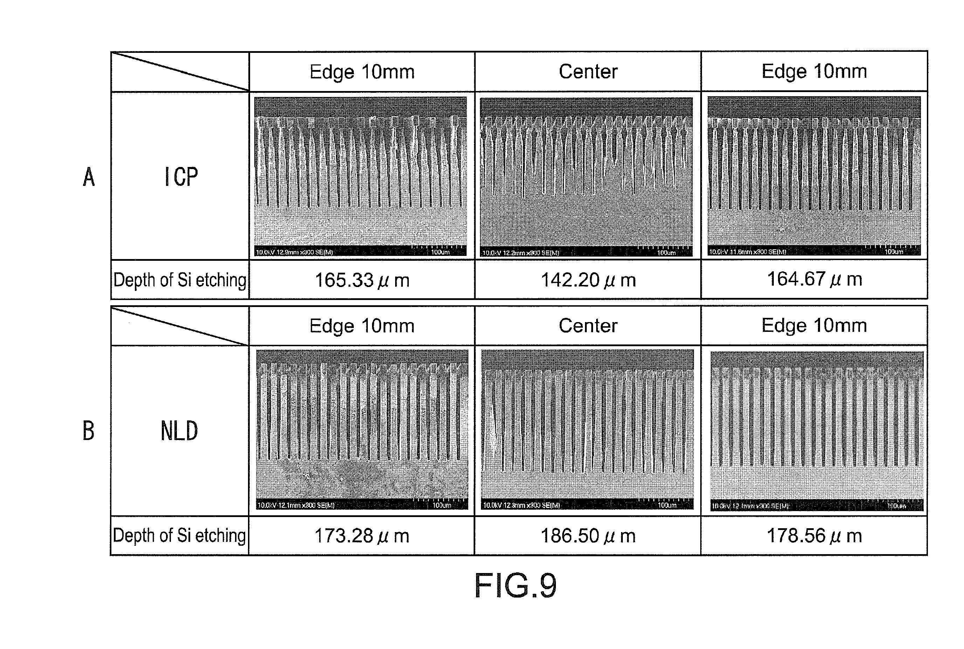

Fig. 7 shows an in-plane distribution of sputtering rates measured for the ICP sputtering and the NLD sputtering. Then, Figs. 8 show in-plane distributions of etching rates measured for each of the ICP etching and the ICP etching. In Figs. 7 and 8, X axes and Y axes represent two orthogonal axial directions on the substrate plane. Further, Figs. 9 show cross-sectional SEM images of processed portions on the silicon substrate (center position of wafer and positions at 10 mm inward from both edge portions in diameter direction) in each of the ICP and the NLD.

As shown in Figs. 9, in the case of the ICP etching, side etching of the silicon substrate is found at a portion immediately below the resist mask. In contrast to this, in the case of the NLD etching, side etching of the silicon substrate is hardly found and it is confirmed that a pattern is formed vertically with respect to the surface of the substrate in a uniform groove width. This is thought because the NLD sputtering has high coverage characteristics of the protective film as compared to the ICP sputtering as described above and as a result, a side wall of the pattern can be effectively protected from side etching.

Further, as shown in Figs. 7 and 8, as to the in-plane distribution of sputtering rates by the ICP sputtering, the wafer center portion is higher than the edge portions, and as to the in-plane distribution of etching rates by the ICP etching, the wafer center portion is lower than the edge portions. As a result, as shown in Figs. 9, the edge portions have a larger degree of side etching of the pattern as compared to the wafer center portion, and in particular, the pattern is tightly narrowed at the portion immediately below the resist mask. Further, as compared to the case of the NLD etching, in-plane variations of an etching depth are large in the case of the ICP etching.

As is apparent from the above results, in the NLD, the in-plane uniformity having an excellent sputtering rate and etching rate is obtained as compared to the ICP, and it is possible to form a uniform protective film on a side wall of the etching pattern over the entire surface of the substrate and realize etching processing vertically with respect to the surface of the substrate. In addition, according to this embodiment, it is possible to increase processing accuracy and improve productivity in the deep processing technique of the silicon substrate.

### (Second embodiment)

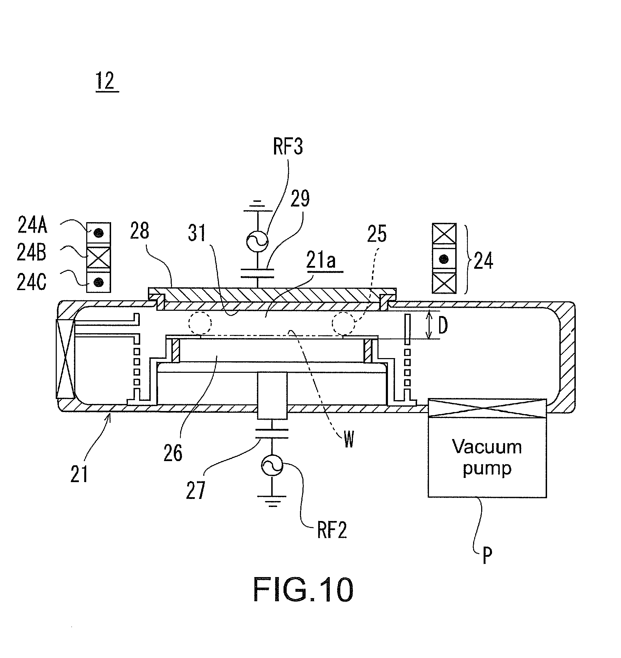

Fig. 10 is a schematic structural diagram of a sputtering apparatus 12 as a plasma processing apparatus according to a second embodiment of the present invention. It should be noted that portions in the figure that correspond to the first embodiment described above are denoted by the same reference symbols, and detailed descriptions thereof will be omitted.

The sputtering apparatus 12 of this embodiment is not provided with the cylindrical wall 22 (Fig. 1) between the vacuum vessel 21 and the top panel 28, and has a structure in which the top panel 28 is directly installed at the upper portion of the vacuum vessel 21. The plasma forming space 21a is formed between the stage 26 and the top panel 28. A gap D between the stage 26 and the top panel 28 is set to 10 mm or more to 40 mm or less.

A high-frequency electric field necessary for generating plasma is formed by the stage 26 and the top panel 28 serving as a counter electrode thereof. That is, the high-frequency electric field is formed in the plasma forming space 21a by capacitive coupling caused between the stage 26 and the top panel 28. Further, the ring-shaped magnetic neutral line 25 is formed in the plasma forming space 21a by the magnetic coil group 24 arranged at the upper portion of the vacuum vessel 21. It should be noted that the ring-shaped magnetic neutral line 25 is formed at a predetermined position in the plasma forming space 21a by setting current (I_{A}) flowing into the magnetic coil 24A to be larger than current (I_{C}) flowing into the magnetic coil 24C.

The plasma forming space 21a generates plasma of the introduced process gas. The target material 31 arranged on the top panel 28 is sputtered by the plasma, and sputtered particles that are beat out from the target material 31 are decomposed by the plasma and deposited on the substrate W. Accordingly, a sputtered film excellent in uniformity with respect to the surface of the substrate W is formed as in the first embodiment described above.

### (Third embodiment)

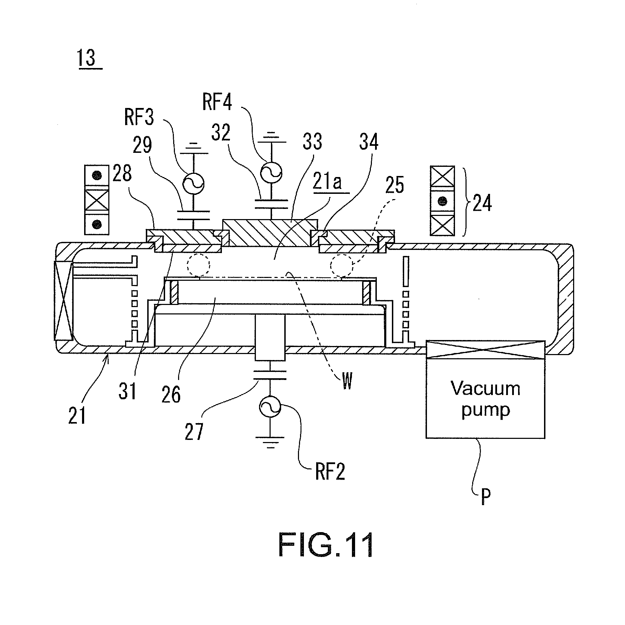

Fig. 11 is a schematic structural diagram of a sputtering apparatus 13 as a plasma processing apparatus according to a third embodiment of the present invention. It should be noted that portions in the figure that correspond to the first embodiment described above are denoted by the same reference symbols, and detailed descriptions thereof will be omitted.

In the sputtering apparatus 13 of this embodiment, the top panel 28 has an opening at the center to thus take a ring shape, and in accordance with this, the target material 31 is also formed in a ring shape. An electrode member 33 is attached to the opening of the top panel 28 via an insulating member 34, and is connected with a fourth high-frequency power source RF4 via a capacitor 32. The fourth high-frequency power source RF4 applies a predetermined high-frequency power to the electrode member 33 to thus form a high-frequency electric field in the plasma forming space 21a, and also generates high-density plasma in the plasma forming space 21a in cooperation with a magnetic neutral line formed by the magnetic coil group 24.

In this embodiment as well, the same operational effect as that of the second embodiment described above can be obtained. Particularly in this embodiment, the fourth high-frequency power source RF4 for forming plasma and the third high-frequency power source RF3 for applying a bias to the top panel 28 are structured as separate power sources. Accordingly, it is possible to structure a plasma processing apparatus that alternately performs a deposition process and an etching process on a substrate W, by periodically switching ON/OFF of power supply to the top panel 28 while keeping the plasma, and introducing etching gas (for example, mixed gas of SF6 and Ar) as process gas at a time when the power supply to the top panel 28 is stopped. In this case, the deposition process is carried out as a process of forming a side-wall protective film for a depressed portion formed on the substrate by etching. With the structure described above, since the deep processing of the silicon substrate that is excellent in processing accuracy and productivity can be realized as in the first embodiment, a hole or a groove having a high aspect ratio can be formed on the surface of the substrate.

### (Fourth embodiment)

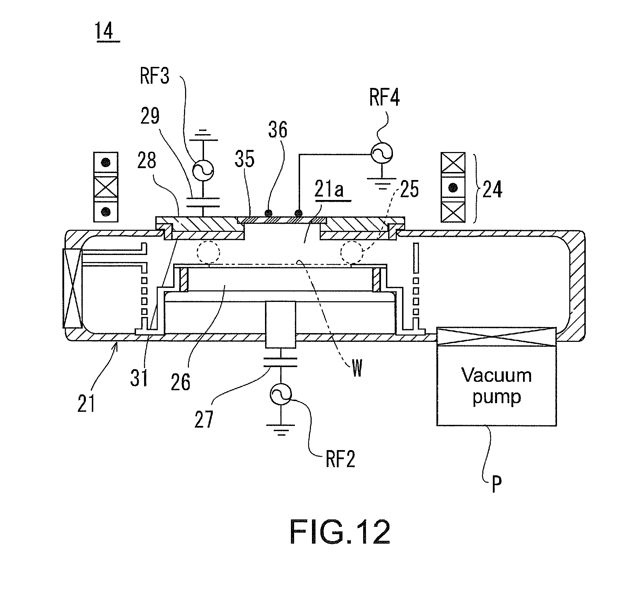

Fig. 12 is a schematic structural diagram of a sputtering apparatus 14 as a plasma processing apparatus according to a fourth embodiment of the present invention. It should be noted that portions in the figure that correspond to the first embodiment described above are denoted by the same reference symbols, and detailed descriptions thereof will be omitted.

In the sputtering apparatus 14 of this embodiment, the top panel 28 has an opening at the center to thus take a ring shape, and in accordance with this, the target material 31 is also formed in a ring shape. A window member 35 formed of a transparent insulating material such as quartz is attached to the opening of the top panel 28, and is attached with an antenna coil 36 connected to a fourth high-frequency power source RF4. The fourth high-frequency power source RF4 applies a predetermined high-frequency power to the antenna coil 36 to thus form an induction electric field in the plasma forming space 21a, and also generates high-density plasma in the plasma forming space 21a in cooperation with a magnetic neutral line formed by the magnetic coil group 24.

In this embodiment as well, the same operational effect as that of the second embodiment described above can be obtained. Further, since the fourth high-frequency power source RF4 for forming plasma and the third high-frequency power source RF3 for applying a bias to the top panel 28 are structured as separate power sources, it is possible to structure a plasma processing apparatus that can alternately perform the etching process and the deposition process as in the third embodiment described above.

Further, by installing a sensor (not shown) for detecting a processed surface of the substrate W at a portion above the transparent window member 35, it is possible to detect a sputtered film thickness and an etching depth of the substrate W. Accordingly, it is possible to detect a surface change of the substrate in real-time, unlike a case where the substrate is detected from a lateral direction.

The embodiments of the present invention have been described up to here. However, the present invention is of course not limited to those embodiments and various modifications can be made based on the technical idea of the present invention.

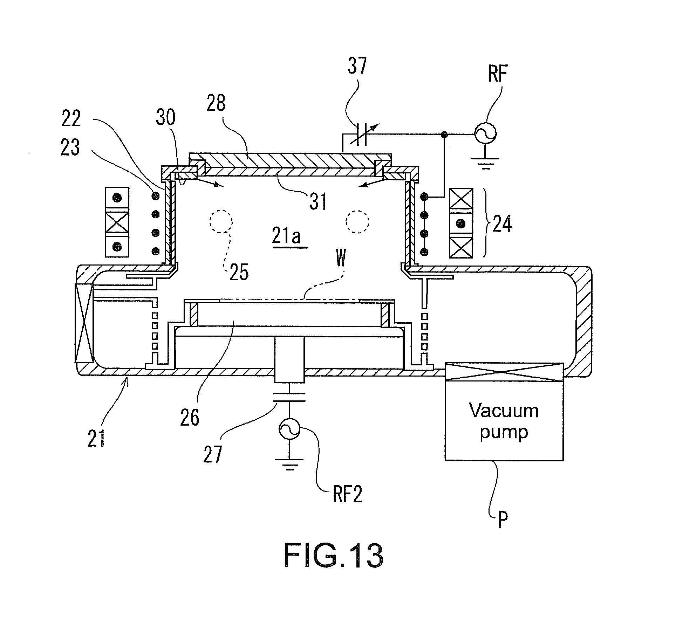

For example, the example in which the first high-frequency power source RF1 for generating plasma and the third high-frequency power source RF3 for biasing the target are structured as separate power sources has been described in the above first embodiment, but the present invention is not limited thereto. As shown in Fig. 13, it is also possible to structure a single high-frequency power source RF as those two high-frequency power sources. It should be noted that reference symbol 37 is a variable capacitor installed between the high-frequency power source RF and the top panel 28.

Further, the example in which the Ar gas is solely used as process gas for forming the protective film has been described in the above embodiments, but the process gas is not limited thereto. For example, as the process gas used in the protective film forming process, mixed gas of Ar and reactive gas (C₄F₈, CHF₃, or the like). In this case, the reactive gas in the process gas is changed into plasma in the plasma forming space 21a, and radical products thereof are deposited on the surface of the substrate to thus form a polymer layer that functions as a protective film. By using the above mixed gas as the process gas, it is possible to increase a sputtering rate as compared to a case of using only the Ar gas as the process gas.

Moreover, the magnetic coil group 24 has been used for forming the magnetic neutral line 25 in the above embodiments, but instead of this, a plurality of permanent magnets arranged outside the vacuum chamber may be used for forming the magnetic neutral line.

In addition, the example in which the sputtering apparatus according to the present invention is applied to the plasma processing apparatus for performing deep processing on the silicon substrate has been described in the above embodiments, but is not limited thereto and is applicable to a normal sputtering apparatus for deposition in which etching processing is not involved.

### Brief Description of Drawings

[Fig. 1] A schematic structural diagram of a plasma processing apparatus according to a first embodiment of the present invention.
[Figs. 2] Timing flows showing an operation example of the plasma processing apparatus of Fig. 1.
[Fig. 3] A diagram showing a relationship between a groove width of a pattern and a coverage ratio by NLD sputtering and ICP sputtering.

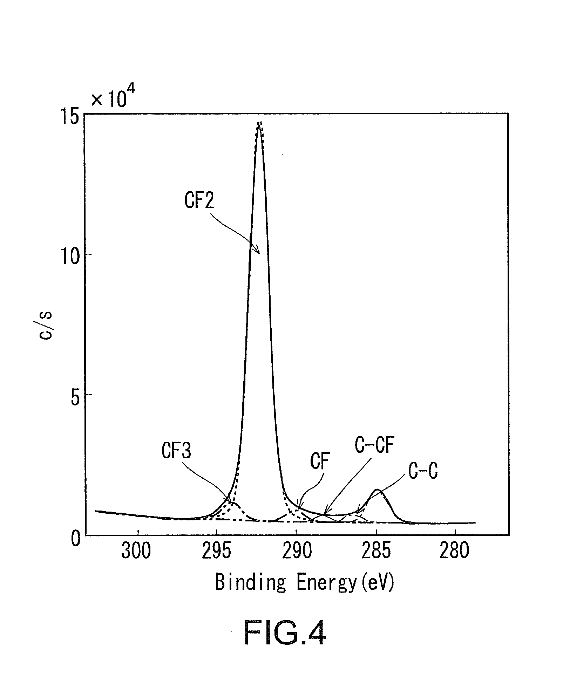

[Fig. 4] A diagram showing a C1ₛ waveform separation spectrum of a target material for sputtering (PTFE).

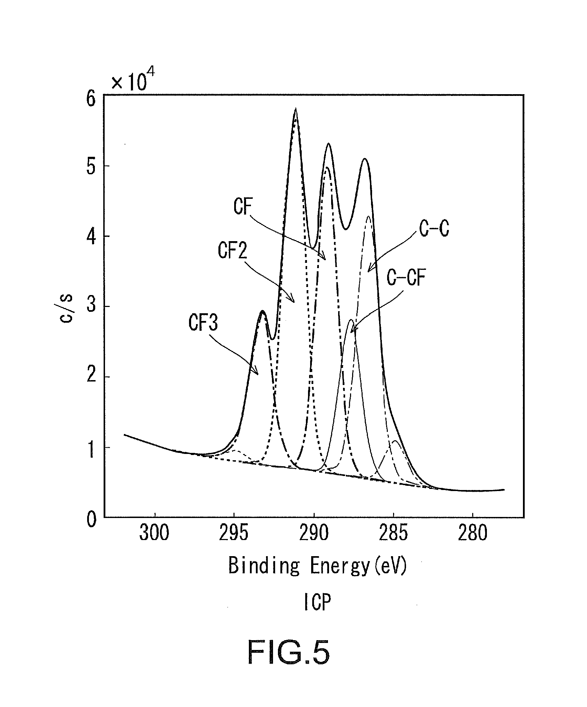

[Fig. 5] A diagram showing a C1ₛ waveform separation spectrum of an ICP-sputtered film.

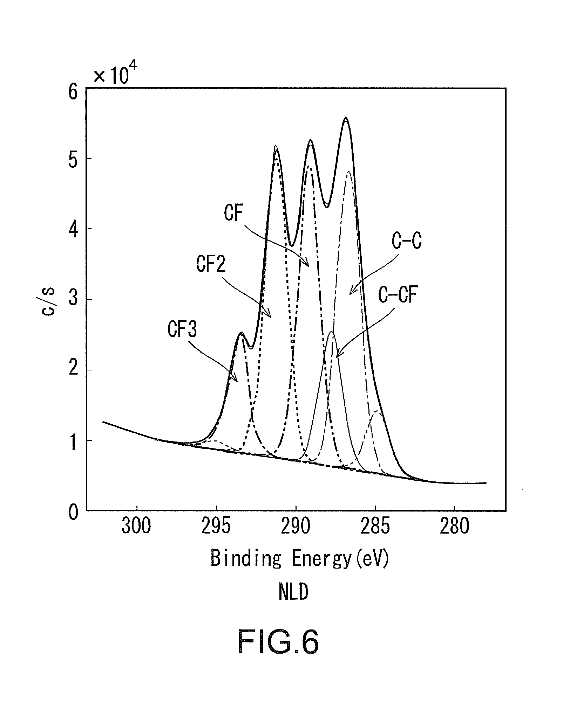

[Fig. 6] A diagram showing a C1ₛ waveform separation spectrum of an NLD-sputtered film.
[Fig. 7] A diagram showing an in-plane distribution of sputtering rates of ICP sputtering and NLD sputtering.
[Figs. 8] Diagrams showing in-plane distributions of etching rates of ICP etching and NLD etching.
[Figs. 9] Diagrams showing an in-plane pattern shape when performing deep processing on a silicon substrate using ICP and NLD.
[Fig. 10] A schematic structural diagram of a sputtering apparatus according to a second embodiment of the present invention.
[Fig. 11] A schematic structural diagram of a sputtering apparatus according to a third embodiment of the present invention.
[Fig. 12] A schematic structural diagram of a sputtering apparatus according to a fourth embodiment of the present invention.
[Fig. 13] A diagram showing a modified example of a structure of the plasma processing apparatus of Fig. 1. Description of Symbols

11-14 sputtering apparatus (plasma processing apparatus)
21 vacuum vessel
21a plasma forming space (vacuum chamber)
23 high-frequency coil (electric field formation means)
24 magnetic coil (magnetic field formation means)
25 magnetic neutral line
26 stage
28 top panel (counter electrode)
30 gas introduction portion
31 target material
33 electrode member (electric field formation means)
35 window member
36 antenna coil (electric field formation means)

## Claims

1. A plasma processing method of generating plasma inside a vacuum chamber and alternately repeating a process of etching a substrate and a process of forming a protective film on a side wall portion of an etching pattern,
wherein the process of forming the protective film includes:
forming a high-frequency electric field and a magnetic neutral line between the substrate and a target material arranged opposite to the substrate and generating plasma; and
sputtering the target material, decomposing sputtered materials thereof by the plasma, and depositing the sputtered materials on the substrate.

2. The plasma processing method according to claim 1,
wherein a surface of the substrate is formed with a projection-depression pattern including a depressed portion having a width of 100 µm or less, and the formation of the magnetic neutral line is controlled so that a ratio of a thickness of a film formed on a side surface of the depressed portion to a thickness of a film formed on an upper surface of a projecting portion of the projection-depression pattern becomes 0.8 or more.

3. The plasma processing method according to claim 2,
wherein the width of the depressed portion is 10 µm or less.

4. The plasma processing method according to claim 1,
wherein the magnetic neutral line is formed by a plurality of magnetic coils or permanent magnets arranged outside the vacuum chamber.

5. The plasma processing method according to claim 1,
wherein the high-frequency electric field is formed by applying a high-frequency power to a high-frequency coil arranged at a circumference or an upper portion of the vacuum chamber.

6. The plasma processing method according to claim 1,
wherein the high-frequency electric field is formed by applying a high-frequency power to a counter electrode that supports the target material installed in an upper portion of the vacuum chamber.

7. The plasma processing method according to claim 1,
wherein the target material is made of a synthetic resin, silicon, carbon, silicon carbide, silicon oxide, or silicon nitride.

8. The plasma processing method according to claim 1,
wherein process gas for generating the plasma is inert gas, fluorine-containing gas, or mixed gas of those gases.

9. A plasma processing apparatus, comprising:
a vacuum chamber;
a stage that is installed inside the vacuum chamber, for supporting a substrate;
a target material that is installed opposite to the stage; and
a plasma source that includes an electric field formation means for forming a high-frequency electric field within the vacuum chamber and a magnetic field formation means for forming a magnetic neutral line within the vacuum chamber, etches the substrate or sputters the target material by plasma generated between the stage and the target material by the electric field formation means and the magnetic field formation means, and decomposes sputtered materials thereof by the plasma to thereby deposit the sputtered materials on the substrate.

10. The plasma processing apparatus according to claim 9,
wherein the magnetic field formation means includes a plurality of magnetic coils arranged outside the vacuum chamber.

11. The plasma processing apparatus according to claim 9,
wherein the electric field formation means includes a high-frequency coil arranged at a circumference or an upper portion of the vacuum chamber.

12. The plasma processing apparatus according to claim 9,
wherein the electric field formation means includes
a counter electrode that is arranged at an upper portion of the vacuum chamber and supports the target material, and
a high-frequency power source connected to the counter electrode.
